Europäisches Patentamt

European Patent Office

Office européen des brevets

(11) Publication number: 0 323 751
A2

# EUROPEAN PATENT APPLICATION

(21) Application number: 88312387.9

(22) Date of filing: 29.12.88

(51) Int. Cl.⁴: H05K 7/18

(30) Priority: 04.01.88 GB 8800025

(43) Date of publication of application:
12.07.89 Bulletin 89/28

(84) Designated Contracting States:
BE DE ES FR IT NL

(71) Applicant: FLEXIFORM LTD
67 Wellington Street
Leeds.LS1 1JL(GB)

(72) Inventor: Nelmes, Robert Speirs
25 Wheatley Avenue Ben Rhydding
Ilkley West Yorkshire(GB)
Inventor: Spencer, Thomas
28 Highfield Drive
Birstall Batley WF17 9BG(GB)

(74) Representative: Ellis, Edward Lovell et al
MEWBURN ELLIS & CO. 2/3 Cursitor Street
London EC4A 1BQ(GB)

(54) Improvements in supporting structures for micro-modules.

(57) A supporting structure for a micro-module or other equipment has a pair of slotted and adjustable rear bracket elements (2,4), a pair of cantilevered support holders (6,8) engageable in slots (32,34) of the rear bracket elements, a rail 10 along which the rear bracket elements are movable, a lower rail (16), the rails being supported by a panel member (12). The support holders (6,8) are provided with side flaps (44) for retaining a micro-module or other piece of equipment (M).

FIG.1.

## Improvements in supporting structures for micro-modules or other equipment

The present invention relates to supporting structures for micro-modules and other equipment, which may or may not be electronic.

Micro-modules and other electronic equipment, e.g. computers, keyboards, and video display units come in a variety of differing shapes and sizes. Conventionally, these micro-modules and other electronic equipment can be arranged on tables or supported on tops fixed to a wall by brackets. As a result, once one has chosen a particular set-up or arrangement of micro-modules, it becomes quite a problem to re-arrange all the micro-modules and other electronic equipment to suit a new layout, especially where some micro-modules may be changed for others of different shapes and sizes or additional micro-modules are added to the original layout. This is particularly the case where the micro-modules and other electronic equipment are supported on surfaces or tops having predetermined areas, which surfaces or tops are fixed to a wall by means of brackets or other support means.

It is therefore an object of the present invention to overcome wholly or partially the above disadvantage.

According to the present invention there is provided a supporting structure for a micro-module or other equipment including: a pair of cantilevered supports; a pair of bracket supports which are horizontally displaceable along a horizontal supporting frame; releasable engagement means provided between respective cantilevered supports and respective bracket supports to allow vertical adjustment of the cantilevered supports.

Said engagement means preferably comprises parallel sets of equi-spaced rectangular slots on said bracket supports and parallel sets of equivalent hook-like members on the rear end of said cantilevered supports.

The bracket supports are preferably made out of one piece of material and are square "C" shaped in profile. The upper arm of the square "C" shaped bracket support preferably is provided with an inverted "U" shaped channel which engages with a rail provided on the horizontal supporting frame.

The cantilevered supports each preferably have one side flange for the purpose of retaining a micro-module in position.

The present invention will now be described in greater detail by way of example with reference to the accompanying drawings, wherein:-

Fig. 1 is a perspective view of one preferred form of supporting structure for micro-modules or other equipment;

Fig. 2 is a side elevation view of one of the rear bracket elements;

Fig. 3 is a side elevation view of the right hand cantilevered support holder; and

Fig. 4 is a plan view of one of the members which make up a cantilevered support holder.

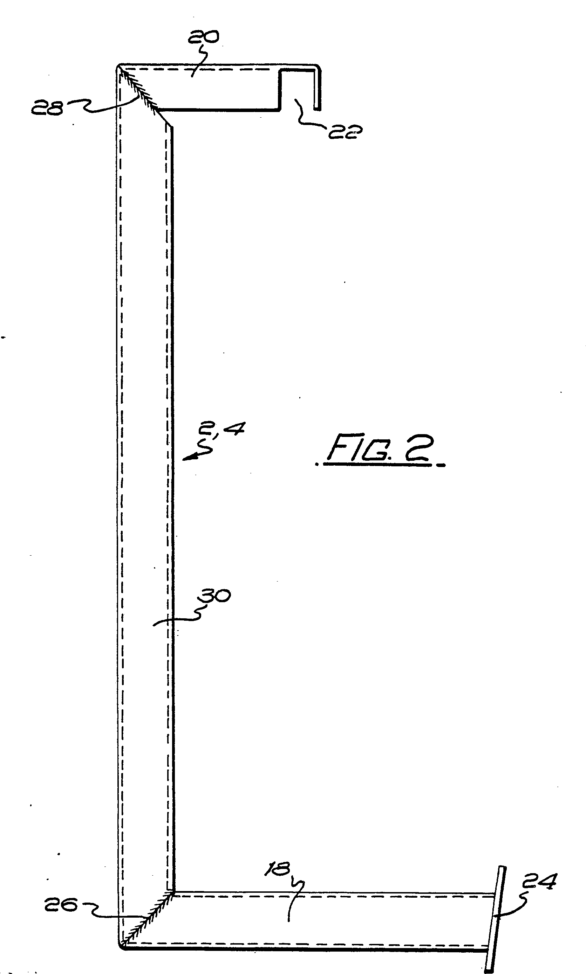

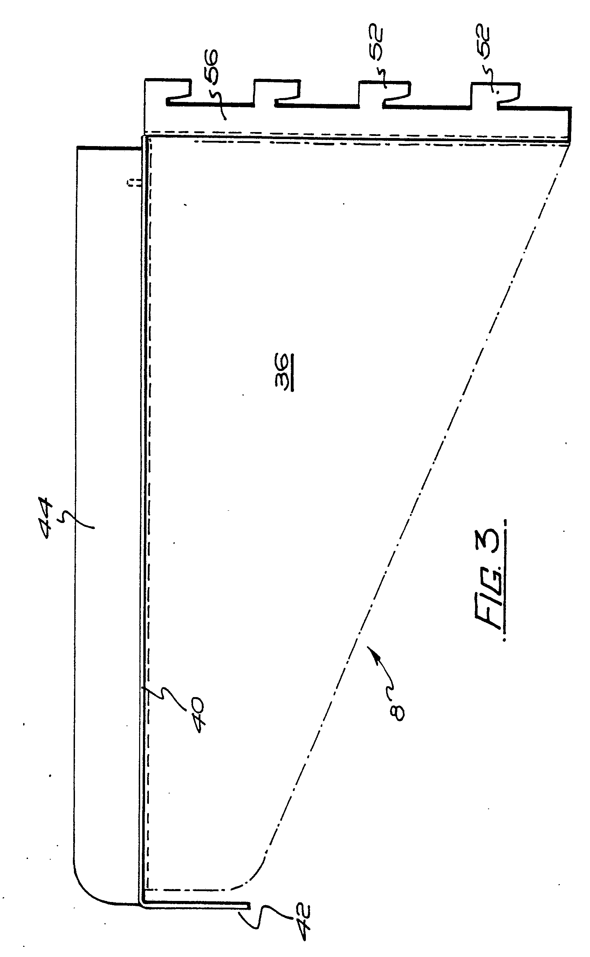

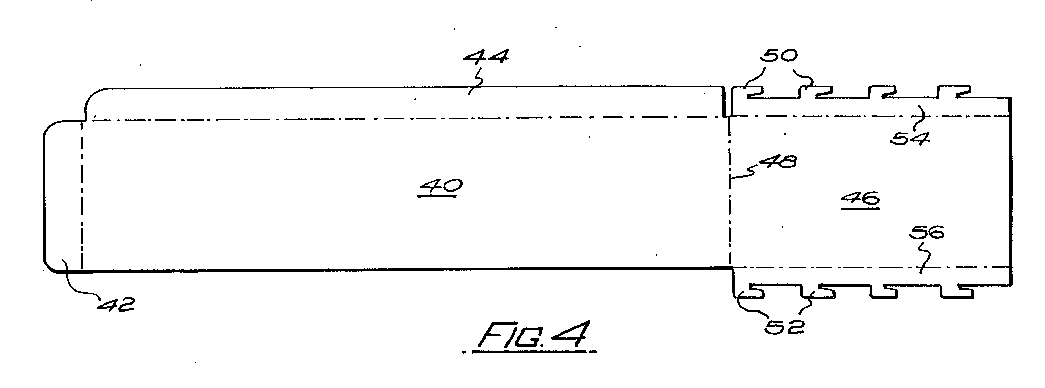

Referring to the drawings the supporting structure for micro-modules or other equipment M comprises four basic separate parts; two slotted and adjustable rear bracket elements 2, and 4, one of which is shown in greater detail in Fig. 2; one left hand cantilevered support holder 6 and one right hand cantilevered support holder 8, the latter being shown in greater detail in Figs. 3 and 4.

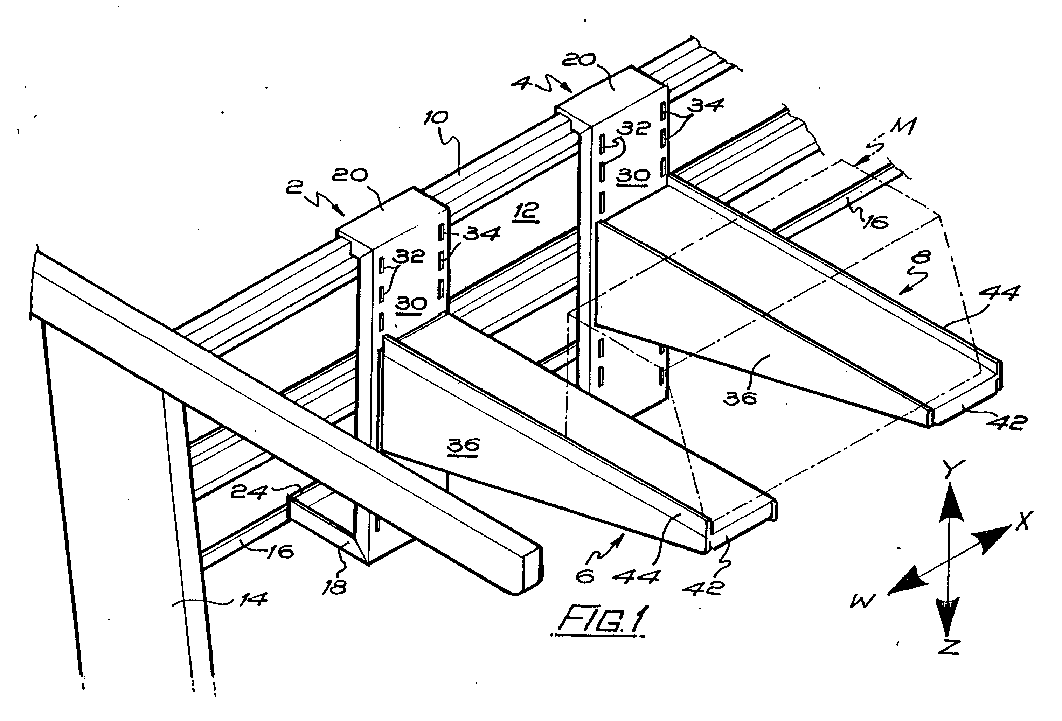

Each of the rear bracket elements 2 and 4 is movable along a horizontal rail 10 which forms part of a horizontal supporting frame constituted by a panel member 12 which can be either secured to the wall of a room or supported between end supports, one end support 14 being shown at the left hand side of Fig. 1. The lower end of each bracket element 2 and 4 rests against a horizontal lower rail 16 at the bottom of the panel member 12.

Referring now more specifically to Fig. 2, each rear bracket element 2 and 4 is substantially square "C" shaped, the lower arm 18 being longer than upper arm 20. Each bracket is made out of a single piece of metal, whose edges are appropriately slotted and cuto to shape prior to folding to form the box-like square "C" shaped structure as shown in Fig. 1. The upper arm 20 is provided with an inverted "U" shaped channel 22 to enable it to slot over the top of the rail 10. The end of the lower arm 18 is slightly out of the vertical and has a plate 24 welded thereto, the plate resting against the lower rail 16 of the panel member 12. The cut edges of the metal sheet are welded at the corners 26 and 28 in order to make the box-like structure rigid. The vertical part 30 of each rear bracket element 2 and 4 is provided with two parallel sets of rectangular slots 32 and 34 which extend the length thereof near to each edge as can be clearly seen in Fig. 1.

Referring now more specifically to Figs. 3 and 4, each cantilevered support holder 6 and 8 is basically made up of three separate members which are cut to shape, bent and welded together to form the composite box-like cantilevered structure shown in Fig. 1. Two of the three members are identical and comprise substantially triangular shaped vertical side members 36. The dimensions of these members is determined by the size and/or weight of the equipment to be supported. The other member is a substantially rectangular plate 40. As shown in its unfolded form in Fig. 4 the horizontal plate 40 has a downwardly projecting front flap 42 and a longitudinal side flap 44, both of which are bent up into the position shown in Fig. 3. The plate 40 also has at its rear end an extended part 46 which is bent downwards at a right angle along a fold line 48. The extended part 46 is provided with parallel sets of hook-shaped members 50 and 52 along its respective longitudinal edges 54 and 56 which are bent rearwards as shown in Fig. 3. Each side member 36 has a rearwardly directed flange (not shown) which is bent inwards at a right angle, the extended part 46 after having been bent down at a right angle is welded to the flanges of side members 36. Each side member 36 is also provided with a longitudinal flange which is bent horizontal and welded to the underside of the horizontal plate 40.

The two parallel sets of hook-shaped members 50 and 52 are arranged to engage into the respective parallel sets of rectangular slots 32 and 34 provided in each rear bracket element 2 or 4.

As will be evident from Fig. 1, the cantilevered support holders 6 and 8 are movable vertically form near the upper end of the rear bracket elements 2 and 4 to near the lower end thereof. The spacing of the rectangular slots 32 and 34 can be quite close to one another so as to allow for plenty of flexibility in adjusting the height of the cantilevered support holders to the desired height. Moreover, each rear bracket element 2 or 4 is independently slidable along the rails 10 and 16 of the panel members 12, so that the width between the cantilevered support holders is readily adjustable to suit different shapes and sizes of micro-modules. The four arrows W, X, Y and Z show the flexibility and versatility of the above-described supporting structure for micro-modules.

Furthermore, the side flaps 44 of each of the cantilevered support holders 6 and 8 are on the outside and so provide a rail for retaining the micro-module firmly in position. The micro-module may project a short distance over the front of the support holders 6 and 8.

The panel member 12 is either hollow or provided with ducts to carry power cables to supply mains power to the micro-modules or carry multi-core cables which interconnect between a plurality of micro-modules.

It will be appreciated that the length of the triangular vertical side members 36 which form part of the cantilevered supports will be determined by the size of the equipment to be supported. The cantilevered supports may conveniently be made with different lengths to make the supporting structure adaptable to different needs. Furthermore, in an alternative construction. The supports may be provided with adjustment means to vary their length either continuously or in discrete steps.

The above described supporting structure for micro-modules or other equipment has the following advantages:-

(a) it is very flexible in both the vertical and horizontal positions allowing micro-modules to be moved or replaced by others of differing shapes and sizes;

(b) the sides of the micro-modules or similar equipment are left completely unobstructed, so that switches, warning lights and plugging in facilities can be easily reached;

(c) the side flange of the cantilevered support holders enable a micro-module to be readily retained in position;

(d) it is robust and rigid, yet easily shifted inn the vertical or horizontal directions which provides it s flexibility; and

(e) it is easy and cheap to manufacture.

In addition to micro-modules, computers, keyboards and video display units referred to above, the supporting structure could support wire baskets for the feeding of printers with continuous stationery.

**Claims**

1. A supporting structure for a micro-module or other equipment (M) comprising a pair of bracket supports (2,4), a pair of cantilevered supports (6,8), releasable engagement means (52,32,34) provided between the respective cantilevered supports and the bracket supports to allow vertical adjustment of the cantilevered supports, characterized in that said bracket supports (2,4) are horizontally displaceable along a horizontal supporting frame (12).

2. A supporting structure according to claim 1, characterized in that said engagement means comprises parallel sets of equi-spaced rectangular slots (32,34) on said bracket supports and parallel sets of equivalent hook-like members (52) on the rear end of said cantilevered supports.

3. A supporting structure according to claim 1 or 2, characterized in that said bracket supports (2,4) are made out of one piece of material and are square "C" shaped in profile.

4. A supporting structure according to claim 3, characterized in that the upper arm (20) of the square "C" shaped bracket support (2,4) is provided with an inverted "U" shaped channel (22) which engages with a rail (10) provided on the horizontal supporting frame (12).

5. A supporting structure according to any one of the preceding claims, wherein the cantilevered supports (6,8) each have one side flange (44) for retaining a piece of equipment carried by said supporting structure.

6. A supporting structure according to any one of the preceding claims, characterized in that the length of the cantilevered supports (6,8) is adjustable either continuously or in discrete steps.

FIG.1

EP 0 323 751 A2

FIG. 2

44

40

42

36

56

52

52

8

FIG. 3

_FIG.4_

EP 0 323 751 A2